# DEMANDE DE BREVET EUROPEEN

(11) **EP 0 913 871 A1**
(43) Date de publication de la demande: **06.05.1999**
(21) Numéro de dépôt: 98410125.3
(22) Date de dépôt: 28.10.1998
(51) Int. Cl.: H01L 29/51, H01L 29/792

(54) **Point mémoire rémanent**

(30) Priorité: 29.10.1997 FR 9713805
(71) Demandeur: STMicroelectronics SA, 94250 Gentilly Cedex (FR)
(72) Inventeur:
(74) Mandataire: de Beaumont, Michel

(57) **Abrégé**

L'invention concerne un point mémoire rémanent, programmable et effaçable électriquement, constitué d'un transistor de type MOS dont l'isolant de grille contient des espèces mobiles chargées. L'isolant de grille est constitué transversalement d'un sandwich comprenant au moins cinq zones :
- des zones intermédiaires (14, 15) ayant des premières valeurs de bande interdite, et
- des zones extrêmes (11, 12) et centrale (13) ayant des valeurs de bande interdite supérieures aux premières valeurs.

## Description

La présente invention concerne un point mémoire rémanent, effaçable et programmable électriquement.

Comme points mémoire rémanents, effaçables et programmables électriquement, il existe essentiellement actuellement des points mémoire de type MNOS et des points mémoire à double grille. Les points mémoire de type MNOS ont l'inconvénient de présenter une durée de rémanence limitée. Les points mémoire à double grille présentent l'inconvénient d'une relative complexité de fabrication et de ne pas être compatibles avec des procédés de fabrication standard de composants CMOS.

Ainsi, un objet de la présente invention est de prévoir un nouveau type de point mémoire réalisable en technologie MOS et de structure simple.

Un autre objet de la présente invention est de prévoir un tel point mémoire qui présente une grande rémanence.

Un autre objet de la présente invention est de prévoir un tel point mémoire dans lequel les opérations de programmation et d'effacement ne nécessitent pas de tension élevée par rapport à la tension de fonctionnement normale d'un circuit CMOS classique.

Un autre objet de la présente invention est de prévoir un tel point mémoire de dimensions minimales.

Pour atteindre ces objets, la présente invention prévoit un point mémoire rémanent, programmable et effaçable électriquement, constitué d'un transistor de type MOS dont l'isolant de grille contient des espèces mobiles chargées. L'isolant de grille est constitué transversalement d'un sandwich comprenant au moins cinq zones dont des zones intermédiaires ayant des premières valeurs de bande interdite, et des zones extrêmes et centrale ayant des valeurs de bande interdite supérieures aux premières valeurs.

Selon un mode de réalisation de la présente invention, les zones intermédiaires sont en un même matériau.

Selon un mode de réalisation de la présente invention, les zones extrêmes et centrale sont en un même matériau.

Selon un mode de réalisation de la présente invention, les zones extrêmes ont une largeur sensiblement égale à la largeur minimale au delà de laquelle il ne se produit pas d'effet tunnel.

Selon un mode de réalisation de la présente invention, les zones extrêmes et centrale sont des couches d'oxyde de silicium et les zones intermédiaires des couches de nitrure de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente l'allure d'un transistor MOS classique ;
les figures 2A, 2B, 2C représentent des vues agrandies d'une couche isolante dans divers états de polarisation ;
la figure 3 est une courbe de concentration en espèces mobiles en fonction de l'épaisseur après polarisation ;
la figure 4 représente une structure de type MNOS ;
la figure 5 représente un exemple de structure d'isolement de grille d'un point mémoire selon la présente invention ; et
la figure 6 représente le diagramme énergétique de la structure de la figure 5.

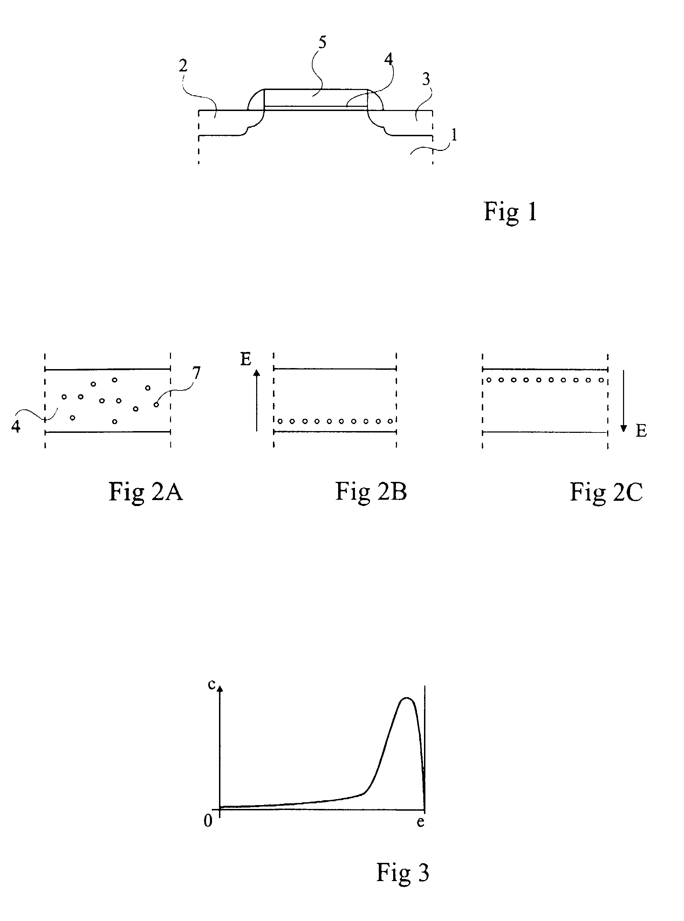

La figure 1 représente très schématiquement une vue en coupe d'un transistor MOS classique comprenant un substrat 1, une région de source 2, une région de drain 3, une couche d'isolement de grille 4 et une couche conductrice de grille 5. Couramment, le substrat est en silicium, la couche isolante en oxyde de silicium et la couche conductrice de grille en silicium polycristallin dopé. Un défaut connu des couches d'isolement de grille 4 est qu'elles sont susceptibles de contenir des ions contaminants résultant du processus de fabrication, par exemple des ions alcalins. Ainsi, on prend classiquement de grandes précautions pour éviter l'introduction de tels défauts lors de la fabrication ou lors du vieillissement des composants, ces ions alcalins pouvant s'introduire par migration dans la couche isolante de grille par l'intermédiaire d'autres couches adjacentes.

L'effet de la présence de ces ions alcalins est illustré en figures 2A à 2C. La figure 2A représente une couche d'isolement de grille 4 dans laquelle des ions alcalins 7 sont présents et répartis de façon aléatoire. Si on applique un champ positif E à la couche d'isolement de grille, par exemple en polarisant la grille positivement par rapport au substrat, les ions alcalins tendront à se rassembler du côté du substrat, comme cela est représenté en figure 2B. Dans le cas d'une polarisation en sens inverse, les ions alcalins tendront à se rassembler du côté de la grille, comme cela est représenté en figure 2C. Ces déplacements des ions alcalins, qui peuvent d'ailleurs être simplement liés au fonctionnement du transistor MOS, perturbent bien entendu les caractéristiques de celui-ci et notamment sa tension de seuil. A l'extrême, un transistor normalement passant peut devenir un transistor normalement bloqué ou inversement.

On a imaginé dans l'art antérieur d'utiliser ce phénomène perturbateur pour conférer à un transistor MOS un effet de mémoire. Dans ce but, on a volontairement introduit des charges mobiles dans des couches d'isolement de grille, par exemple, des ions d'hydrogène ou de deutérium. Alors, on conçoit que les deux états illustrés en figures 2B et 2C correspondent à deux états de mémorisation reconnaissables en lecture. Ce type de mémoire n'a pas atteint un grand succès car il souffre de défauts de fiabilité et d'une rémanence limitée.

A titre d'exemple, la figure 3 représente une courbe de concentration c d'espèces mobiles en fonction de l'épaisseur e de la couche isolante. Après une opération de programmation ayant amené les charges au fond de la couche isolante, la répartition des porteurs de charge est sensiblement celle illustrée en figure 3. Toutefois, cet état n'est pas fondamentalement stable pour les raisons suivantes.

Premièrement, sous l'effet de relaxations naturelles et de perturbations dues à des lectures répétées du système, la répartition des charges tend à s'uniformiser. L'état de mémorisation disparaît alors. Il faut donc prévoir un rafraîchissement périodique.

Deuxièmement, un autre problème est lié aux phénomènes de recombinaison. Des espèces chargées se trouveront inévitablement très près de l'interface avec une couche adjacente (le substrat ou la grille). Si elles se trouvent à une distance de l'interface à laquelle peut se produire un effet tunnel, ces charges risquent de se recombiner avec des porteurs libres existant de l'autre côté de l'interface. Ainsi, au cours du temps, le nombre d'ions actifs dans le phénomène de mémorisation tend à diminuer et la mémoire devient inévitablement inopérante ou en tout cas présente des seuils moins nettement différenciés.

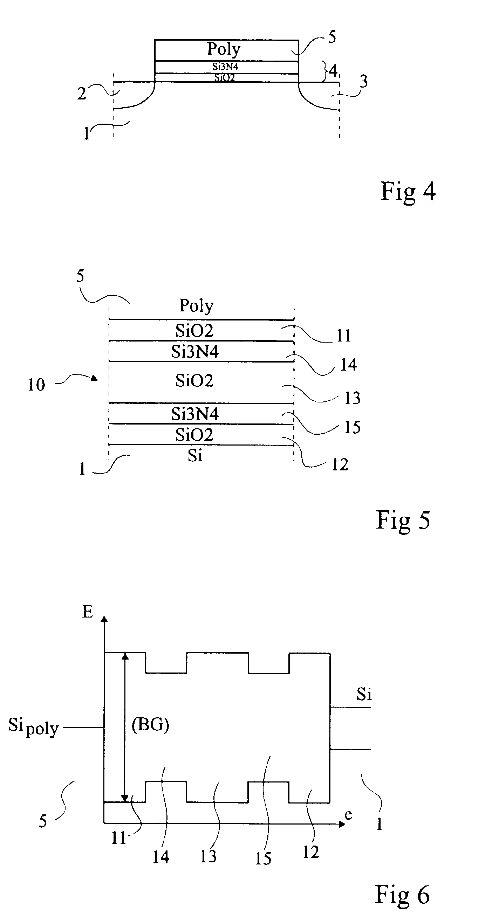

La figure 4 représente une autre structure de type MOS ayant un effet mémoire dans laquelle l'isolant de grille est formé d'une couche de nitrure de silicium (du côté de la grille) et d'une couche d'oxyde de silicium (du côté du substrat). Cette mémoire, dite MNOS, fonctionne par injection à chaque programmation d'électrons ou de trous qui viennent se placer à l'interface entre le nitrure de silicium et l'oxyde de silicium. Il s'agit là aussi d'une mémoire à faible rémanence, les électrons et trous étant fort susceptibles de se recombiner ou de se répartir par relaxation. De plus comme on le verra ci-après les électrons ou les trous sont susceptibles d'être piégés à des niveaux intermédiaires et de ne pas être localisés avec précision.

La présente invention prévoit une nouvelle structure de point mémoire dans laquelle les états de mémorisation sont nettement différenciés et stables dans le temps.

Ce point mémoire comporte une structure de type transistor MOS dans laquelle l'isolant de grille est constitué d'un sandwich tel qu'illustré en figure 5. Ce sandwich contient des couches ou zones extrêmes 11 et 12, une couche ou zone médiane 13 et des couches ou zones intermédiaires 14 et 15.

Ces diverses couches ou zones doivent selon l'invention présenter des caractéristiques telles qu'illustrées en figure 6 qui représente un diagramme d'énergie en fonction de l'épaisseur. La distance entre deux traits horizontaux de même abscisse correspondant à une zone donnée définit la largeur de la bande interdite (BG) du matériau de la zone correspondante. Ainsi, on choisit les zones extrêmes 11 et 12 et la zone médiane 13 pour qu'elles présentent une largeur de bande interdite supérieure à la largeur de bande interdite du matériau constituant les zones intermédiaires 14 et 15. On a considéré, dans la partie gauche de la figure, que le silicium polycristallin était parfaitement conducteur et que ses charges mobiles étaient situées dans sa bande de conduction, et, dans la partie droite de la figure, que le silicium du substrat présentait une bande interdite de faible hauteur, ce qui est caractéristique d'un semiconducteur par rapport à un isolant.

Ainsi, pour les espèces mobiles chargées (ions alcalins, ions hydrogène, ions deutérium ou autres) présentes dans l'isolant 10, il existe deux zones stables qui correspondent aux zones 14 et 15, et qui constituent des puits de potentiel encadrés par des barrières de potentiel. En appliquant un champ électrique suffisant de polarité positive ou négative, on pourra donc amener les charges mobiles à se trouver dans l'une ou l'autre de ces deux zones. Une fois qu'elles se trouvent dans l'une de ces zones, les charges mobiles ne peuvent plus en sortir sans que l'on applique à l'isolant un champ propre à leur faire franchir la barrière de potentiel pour leur permettre de passer de la zone 14 à la zone 15 ou inversement.

Les zones extrêmes 11 et 12 sont choisies d'une épaisseur suffisante pour interdire toute recombinaison des charges mobiles contenues dans le puits adjacent avec les charges libres présentes dans la zone adjacente (substrat ou grille dans ce mode de réalisation) et éviter ainsi une disparition des charges par recombinaison. En d'autres termes, cette épaisseur est telle qu'il ne puisse se produire d'effet tunnel à travers la zone adjacente considérée. L'épaisseur de la zone centrale 13 devra bien entendu être également supérieure à ce seuil, mais sera de préférence nettement plus épaisse pour bien différencier les deux états de mémorisation.

On notera que la présente invention fait appel à un système dans lequel des charges sont préexistantes dans l'isolant, contrairement au cas de structures de type MNOS. De plus, il s'agit de charges de type ionique et non pas d'électrons ou de trous. Ceci est fondamental car, pour des électrons et des trous, il existerait des zones de piégeage au niveau de la couche centrale ou des couches extrêmes et les électrons et les trous ne se positionneraient pas totalement à l'intérieur des puits de potentiel constitués par les zones 14 et 15.

A titre d'exemple d'une structure satisfaisant à la définition de la présente invention, on peut prévoir que les couches extrêmes 11 et 12 sont des couches d'oxyde de silicium d'une épaisseur supérieure à 3 à 4 nm (30 à 40 angströms), l'effet tunnel ne se manifestant que pour des épaisseurs inférieures à sensiblement 30 angströms. La couche centrale 13 peut être une couche d'oxyde de silicium d'une épaisseur supérieure à 30 angströms. Elle peut être nettement plus épaisse si l'on souhaite différencier nettement les deux états, au prix d'une augmentation de la tension de programmation pour faire passer les charges libres d'un état à l'autre. Chacune des couches intermédiaires peut avoir une épaisseur de l'ordre de 30 à 40 angströms. A nouveau, la valeur supérieure de ces épaisseurs n'est pas limitée par des considérations physiques mais seulement par le souhait de mieux définir chacun des états de la mémoire. Ce système répond bien aux exigences de l'invention, l'oxyde de silicium ayant une bande interdite d'une valeur de l'ordre de 11 électronvolts alors que le nitrure de silicium a une bande interdite d'une valeur de l'ordre de 8 électronvolts. On pourrait choisir d'autres systèmes, par exemple SiO₂-Ta₂O₅, SiO₂-TiO₂, etc. On pourrait également envisager une couche isolante unique dont l'état serait modifié localement dans deux zones de son épaisseur, par exemple une couche d'oxyde de silicium dont des régions intermédiaires auraient été modifiées par implantation d'azote et de silicium.

Pour réaliser une programmation amenant les charges au voisinage du substrat, on pourra connecter la grille à un potentiel positif tandis que le substrat, le drain et la source sont connectés à la masse. Inversement, pour effectuer une programmation dans laquelle les charges mobiles deviennent voisines de la grille, on appliquera un potentiel positif sur le substrat, le drain et la source et on reliera la grille au potentiel de la masse. Bien entendu, ceci correspond au cas où les espèces mobiles sont des ions positifs. Tout ce qui a été décrit précédemment pourra être inversé dans le cas où ces espèces mobiles seraient des ions négatifs.

De préférence, on choisira la dimension de la couche centrale et on sélectionnera des matériaux de bandes interdites appropriées pour que la tension propre à faire passer les charges mobiles d'un puits de potentiel dans un autre soit par exemple de l'ordre de 4 volts pour un dispositif destiné à fonctionner en lecture à une tension de l'ordre de 2 volt, de sorte que la lecture ne soit pas susceptible de modifier la programmation.

La présente invention n'est pas limitée à la réalisation d'une mémoire à deux états. On pourrait obtenir un système à trois états en remplaçant la zone centrale par un sandwich de plusieurs couches à valeurs de bande interdites distinctes, la valeur de la bande interdite de la couche centrale étant la plus faible, par exemple un sandwich oxyde-nitrure-oxyde.

## Revendications

1. Point mémoire rémanent, programmable et effaçable électriquement, constitué d'un transistor de type MOS dont l'isolant de grille est constitué transversalement d'un sandwich comprenant au moins cinq zones :
- des zones intermédiaires (14, 15) ayant des premières valeurs de bande interdite, et
- des zones extrêmes (11, 12) et centrale (13) ayant des valeurs de bande interdite supérieures aux premières valeurs,
caractérisé en ce que l'isolant de grille contient de façon permanente des espèces mobiles chargées.

2. Point mémoire selon la revendication 1, caractérisé en ce que les zones intermédiaires sont en un même matériau.

3. Point mémoire selon la revendication 1 ou 2, caractérisé en ce que les zones extrêmes et centrale sont en un même matériau.

4. Point mémoire selon la revendication 1, caractérisé en ce que les zones extrêmes ont une largeur sensiblement égale à la largeur minimale au delà de laquelle il ne se produit pas d'effet tunnel.

5. Point mémoire selon la revendication 1, caractérisé en ce que les zones extrêmes et centrale sont des couches d'oxyde de silicium et les zones intermédiaires des couches de nitrure de silicium.
